# EUROPÄISCHE PATENTSCHRIFT

(11) **EP 0 389 656 B1**
(45) Veröffentlichungstag und Bekanntmachung des Hinweises auf die Patenterteilung: **18.01.1995**
(21) Anmeldenummer: 89105601.2
(22) Anmeldetag: 30.03.1989
(51) Int. Cl.: H01R 13/74, H05K 7/14

(54) **Vorrichtung zum Befestigen von Steckerleisten**
Device for mounting pin-carrying connectors
Dispositif de fixation pour des réglettes à fiches

(43) Veröffentlichungstag der Anmeldung: 03.10.1990
(73) Patentinhaber: Rittal-Werk Rudolf Loh GmbH & Co. KG, 35745 Herborn (DE)
(72) Erfinder: Fursier, Roger, Longlands, Saltash Cornwall PL12 4QQ (GB); Keens, Gary, Plymouth Devon PL6 6AU (GB)
(74) Vertreter: Fleck, Hermann-Josef, Dr.-Ing.

(56) Entgegenhaltungen:
- EP-A- 0 105 151
- DE-A- 2 748 065
- FR-A- 2 353 970

## Beschreibung

Die Erfindung betrifft eine Vorrichtung zum Befestigen von Steckerleisten an Trägern, Platten oder dgl., bei der die Steckerleisten an ihren Schmalseiten in Befestigungsflansche auslaufen, auf die Halteklammern aufgesteckt sind, wobei die Halteklammern in Durchbrüche der Träger oder dgl. einführbar sind und diese hintergreifende Rastansätze aufweisen.

Gerade in Baugruppenträgern ist oft eine Vielzahl von Steckerleisten für Einschübe mit einer komplementären Steckerleiste an den im Bereich der Rückseite des Baugruppenträgers angebrachten Querträgern zu befestigen. Die Steckerleisten laufen an ihren Schmalseiten in Befestigungsflansche mit Befestigungsbohrungen aus, so daß sie mittels Schraubverbindungen an den Querträgern angebracht werden können. Die Querträger weisen dabei Reihen von Bohrungen für die Befestigungsschrauben auf. Diese Art der Befestigung der Steckerleisten erfordert neben den Elementen der Schraubverbindungen einen ganz beachtlichen Montageaufwand.

Eine Vorrichtung der eingangs beschriebenen Art ist in der FR-A-2 353 970 als bekannt ausgewiesen. Bei dieser bekannten Vorrichtung handelt es sich um eine Halteklammer, mit der ein Stecker an einer Leiterplatte befestigbar ist. Die Halteklammer besitzt einen eingebogenen Endabschnitt, mit dem sie in eine Aussparung an der Stirnseite des Steckers eingelegt wird, und zwei umgebogene seitliche Lappen, mit denen sie seitlich an dem Stecker gehalten ist.

Es ist Aufgabe der Erfindung, eine Vorrichtung der eingangs erwähnten Art zu schaffen, bei der mit einfachen Befestigungsmitteln die Steckerleiste einfach und schnell an den Querträgern oder anderen Trägern, Platten oder dgl. festgemacht werden kann.

Diese Aufgabe wird nach der Erfindung dadurch gelöst, daß die Halteklammern in einer Ebene längs zu den Steckerleisten und quer zum Träger oder dgl. U-förmig ausgebildet und in Längsrichtung der Steckerleiste von deren Stirnseiten her gegeneinander gerichtet auf die Befestigungsflansche aufsteckbar sind.

Bei dieser Vorrichtung brauchen die Halteklammern nur auf die Befestigungsflansche der Steckerleiste aufgesteckt zu werden, dann kann die Steckerleiste mit den Halteklammern an den Querträgern oder dgl. eingerastet werden, wobei die Rastfedern mit den Rastansätzen automatisch die Verbindung der Steckerleiste mit den Querträgern oder dgl. übernehmen. In der Verbindungsstellung können sich die Halteklammern nicht mehr von den Befestigungsflanschen lösen, da die Durchbrüche in den Baugruppenträgern auf die Verteilung der Halteklammern benachbarter Steckerleisten und auf den Abstand der beiden Halteklammern einer Steckerleiste abgestimmt sind. Die Montage erfordert daher nur noch eine einfache Handhabung, die zudem sehr schnell ausführbar ist. Durch Aufheben der Rastverbindungen der Halteklammern mit den Querträgern oder dgl. kann die Steckerleiste jedoch auch wieder gelöst werden.

Ist nach einer Ausgestaltung vorgesehen, daß die Halteklammern und die Rastfedern mit den Rastansätze jeweils einstückig ausgebildet und als Stanz-Biege-Teil aus einem elastischen Metall hergestellt sind, dann ergeben sich einfache und preisgünstig herstellbare Halteklammern.

Die Ausgestaltung der Halteklammern ist im einzelnen so, daß die U-förmigen Halteklammern jeweils aus einem an einem Steg abgebogenen Endschenkel und einem aus dem Steg ausgestanzten und ausgebogenen Lappen gebildet sind, wobei die Endschenkel an den den Querträgern oder dgl. zugekehrten Seiten und die Lappen an den den Querträgern oder dgl. abgekehrten Seiten der Befestigungsflansche der Steckerleiste anliegen.

Eine ausreichend große Federlänge für die Rastfedern und ihre Rastansätze ergibt sich nach einer Ausgestaltung dadurch, daß die den Querträgern oder dgl. abgekehrten Seiten der Stege der U-förmigen Halteklammern außerhalb der Lappen verlängert und um 180° auf die Außenseite des Steges umgebogen als Rastfedern ausgebildet sind, die an ihren freien Enden hakenförmig umgebogen sind und mit den umgebogenen Abschnitten die Rastansätze bilden.

Um eine eindeutige Stellung der auf die Befestigungsflansche der Steckerleiste aufgesteckten Halteklammern zu erhalten, sieht eine Ausgestaltung vor, daß die Befestigungsflansche der Steckerleiste auf den den Querträgern oder dgl. abgekehrten Seiten die Lappen der U-förmigen Halteklammern an mindestens zwei freien Seiten mittels Stegen oder Absätzen gegen Verdrehen sichern. Die Rastfedern mit den Rastansätzen stehen dann stets in derselben Stellung im Bezug auf die Durchbrüche in den Querträgern oder dgl.

Ist vorgesehen, daß die Halteklammern in Bezug auf ihre in Längsrichtung der Steckerleiste verlaufende Mittelebene symmetrisch ausgebildet sind, dann sind für beide Schmalseiten der Steckerleiste identische Halteklammern verwendbar.

Eine wahlweise Verbindung mittels Schraubverbindungen oder Rastverbindungen ist dadurch möglich, daß die Querträger oder dgl. pro Schmalseite der Steckerleiste eine Reihe von Bohrungen und eine Reihe von Durchbrüchen aufweisen, die in Längsrichtung der Querträger oder dgl. ausgerichtet und quer dazu aufeinander ausgerichtet sind, und daß der mittlere Abstand der einander zugeordneten Reihen von Bohrungen und Durchbrüchen dem mittleren Abstand der Befestigungsbohrung im Befestigungsflansch der Steckerleiste und der Rastgeber mit dem Rastansatz der auf diesem Befestigungsflansch aufgesteckten Halteklammer entspricht.

Die Erfindung wird anhand eines in den Zeichnungen dargestellten Ausführungsbeispiels näher erläutert. Es zeigt:
Fig. 1 eine perspektivische Teilansicht, die die Befestigung der Steckerleiste mittels Halteklammern an Querträgern eines schematisch angedeuteten Baugruppenträgers verdeutlicht, und
Fig. 2 in vergrößerter Darstellung die Steckerleiste ohne und mit aufgesteckten Halteklammern.

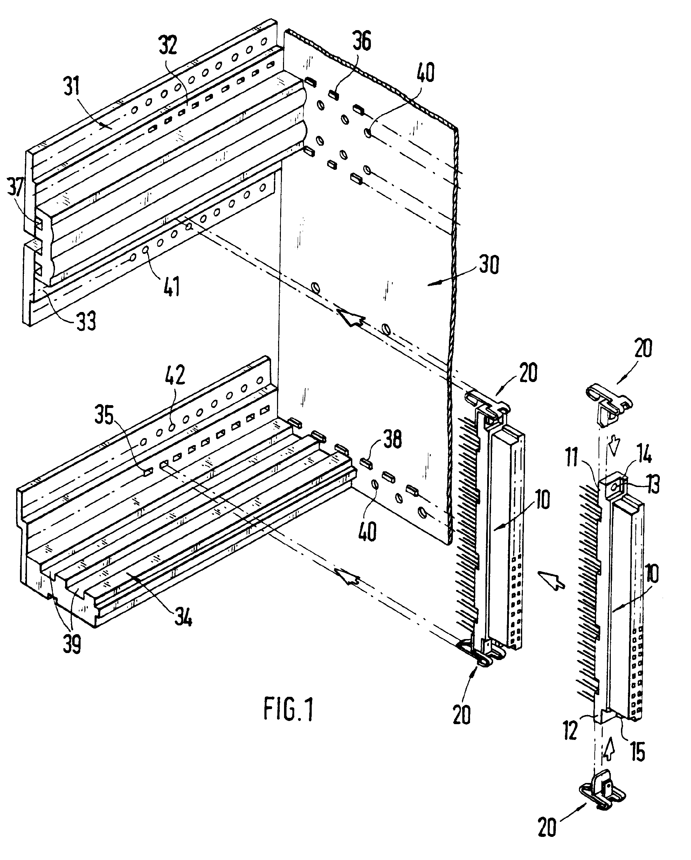

In Fig. 1 sind von dem Baugruppenträger nur eine Seitenplatte 30 und die beiden Querträger 31 und 34 im Bereich der Rückseite schematisch angegeben. Der Querträger 34 bildet z.B. den unteren Abschluß, während am Querträger 31 zwei Steckerleisten nach unten bzw. nach oben gerichtet mit den einander zugekehrten Schmalseiten befestigt werden können. Die Querträger 31 und 34 sind Profilabschnitte, die mit ihren Stirnseiten mit den Seitenplatten 30 des Baugruppenträgers verbunden werden. Die Seitenplatten 30 weisen dazu Befestigungsbohrungen 40 auf. Außerdem stehen an den Innenseiten der Seitenplatten 30 Ansätze 36 und 38 vor, die die Festlegung der Querträger 31 und 34 in Verbindung mit den Stegen, Kanälen 37 und Nuten 39 nur in vorgegebenen Positionen zulassen.

Die Querträger 31 und 34 weisen Reihen von Durchbrüchen 32, 33 und 35 auf, die in ihrer Anordnung und Verteilung auf die Befestigungsmaße der Steckerleisten 10 abgestimmt sind. Die Steckerleisten 10 können als Steckbuchsenleiste oder Messerkontaktleiste ausgebildet sein. Bei dem gezeigten Ausführungsbeispiel ist die Steckerleiste 10 mit Steckbuchsenkontakten versehen, in die Messerkontakte der komplementären Steckerleiste von Einschüben einführbar sind. Der Isolierkörper der Steckerleiste 10 läuft an den Schmalseiten in die Befestigungsflansche 11 und 12 aus, die für die übliche Schraubbefestigung mit den Befestigungsbohrungen 13 versehen sind.

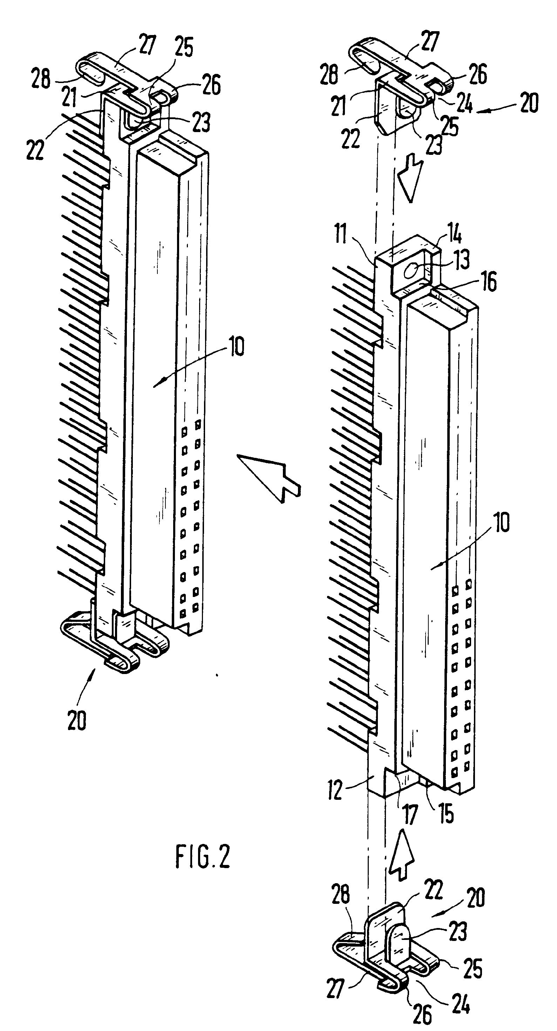

Die Befestigung der Steckerleiste 10 erfolgt mittels zweier U-förmiger Halteklammern 20, die wie die vertikalen Pfeile in Fig. 2 zeigen, gegeneinander gerichtet auf die Befestigungsflansche 11 und 13 aufgesteckt werden. Die Halteklammern 20 sind als Stanz-Biege-Teil aus elastischem Metall hergestellt. Der Endschenkel 22 ist an dem Steg 21 senkrecht abgebogen und aus dem Steg 21 ist der Lappen 23 ausgestanzt und ausgebogen, so daß der Endschenkel 22 den Befestigungsflansch 11 bzw. 13 an der dem Querträger 31 bzw. 34 zugekehrten Seite und der Lappen 23 an der dem Querträger 31 bzw. 34 abgekehrten Seite anliegen. Die dem Querträger 31 bzw. 34 abgekehrte Seite der Befestigungsflansche 11 bzw. 13 sind zumindest an zwei freien Seiten der Lappen 23 mittels Stege 14 bzw. 15 oder Absätze 16 bzw. 17 abgeschlossen, so daß der Lappen 23 und damit die Halteklammer 20 unverdrehbar gehalten ist und stets dieselbe Position am Befestigungsflansch 11 bzw. 13 einnimmt. Da die Halteklammern 20 zu ihrer in Längsrichtung der Steckerleiste 10 verlaufenden Mittelebene symmetrisch sind, können identische Halteklammern 20 für beide Befestigungsflansche 11 und 13 verwendet werden.

Der Steg 21 der Halteklammer 20 geht im Bereich der Ausstanzung 24 über die restlichen Außenteile 25 und 26 in die Rastfeder 27 über, die etwa parallel zum Steg 21 um 180° auf dessen Außenseite umgebogen und am freien Ende hakenförmig eingebogen ist. Der Endabschnitt dient dabei als Rastansatz 28, der beim Einstecken der Rastfeder 27 in einen Durchbruch 32, 33 oder 35 des Querträgers 31 oder 34 hinter diesem einrastet und die Steckerleiste 10 an dem Querträger 31 bzw. 34 festlegt. Die Ausgestaltung ist dabei so, daß die Rastfeder 27 und der Rastansatz 28 mit ihren Breitseiten parallel zu den Längsseiten der rechteckförmigen Durchbrüche 32, 33 und 35 verlaufen. Die Schmalseiten der Durchbrüche 32, 33 und 35 sind dabei kleiner als der maximale Abstand des Rastansatzes 28 von der Rastfeder 27, um den Rastvorgang sicherzustellen. Die Halteklammer 20 ist mit der Rastfeder 27 und dem Rastansatz 28 als einstückiges Stanz-Biege-Teil aus elastischem Metall hergestellt. Wie die Reihen von Bohrungen 41 und 42 der Querträger 31 und 34 zeigen, können die Steckerleisten 10 nach wie vor auch mittels Schraubverbindungen mit den Querträgern 31 und 34 verbunden werden.

Wie aus der Fig. 2 leicht zu ersehen ist, ist der Abstand der beiden Rastansätze 28 der auf die beiden Befestigungsflansche 11 und 13 aufgesteckten Halteklammern 20 größer als der Abstand der Befestigungsbohrungen 13 in den Befestigungsflanschen 11 und 13 der Steckerleiste 10. Daher ist auch der Abstand der Reihen von Durchbrüchen 33 und 35 in den Querträgern 31 und 34 entsprechend größer als der Abstand der Reihen von Bohrungen 41 und 42 in diesen Querträgern 31 und 34. Daher kann wahlweise die Schraub- oder Rastbefestigung für die Steckerleisten gewählt werden. Da die Rastfedern 27 außerhalb der Steckerleiste 10 liegen, können die Querträger 31 und 34 zwischen der Reihe von Durchbrüchen 33 bzw. 35 und den Reihen von Bohrungen 41 bzw. 42 Absätze aufweisen, die die Schmalseiten der Steckerleiste 10 fixieren. Die Länge der Rastfedern 27 mit den Rastansätzen 28 ist auf diese Absätze, d.h. die größere Dicke der Querträger 31 und 34 im Bereich der Durchbrüche 32, 33 und 35 abgestimmt. Die Bohrungen 41 und 42 sind quer zu den Querträgern 31 und 34 aufeinander ausgerichtet und der mittlere Abstand der einer Schmalseite der Steckerleiste 10 zugeordneten Reihe von Bohrungen 41 bzw. 42 von der Reihe von Durchbrüchen 32, 33 bzw. 35 entspricht dem mittleren Abstand der Befestigungsbohrung 13 des Befestigungsflansches 11 bzw. 12 von der Rastfeder 27 mit dem Rastansatz 28 der auf diesen Befestigungsflansch 11 bzw. 12 aufgesteckten Halteklammer 20.

## Patentansprüche

1. Vorrichtung zum Befestigen von Steckerleisten (10) an Trägern (31,34), Platten oder dgl., bei der die Steckerleisten (10) an ihren Schmalseiten in Befestigungsflansche (11,12) auslaufen, auf die Halteklammern (20) mit Rastfedern (27) aufgesteckt sind, die in Durchbrüche (32,33, 35) der Träger (31,34) oder dgl. einführbar sind und diese hintergreifende Rastansätze (28) aufweisen,
dadurch gekennzeichnet,
daß die Halteklammern (20) in einer Ebene längs zu den Steckerleisten (10) und quer zum Träger (31,34) oder dgl. U-förmig ausgebildet und in Längsrichtung der Steckerleiste (10) von deren Stirnseiten her gegeneinander gerichtet auf die Befestigungsflansche (11,12) aufsteckbar sind.

2. Vorrichtung nach Anspruch 1,
dadurch gekennzeichnet,
daß die Halteklammern (20) und die Rastfedern (27) mit den Rastansätzen (28) jeweils einstückig ausgebildet und als Stanz-Biege-Teil aus einem elastischen Metall hergestellt sind.

3. Vorrichtung nach Anspruch 1 oder 2,
dadurch gekennzeichnet,
daß die U-förmigen Halteklammern (20) jeweils aus einem an einem Steg (21) abgebogenen Endschenkel (22) und einem aus dem Steg (21) ausgestanzten und ausgebogenen Lappen (23) gebildet sind, wobei die Endschenkel (22) an den den Querträgern (31,34) oder dgl. zugekehrten Seiten und die Lappen (23) an den den Querträgern (31,34) oder dgl. abgekehrten Seiten der Befestigungsflansche (11,12) der Steckerleiste (10) anliegen.

4. Vorrichtung nach einem der Ansprüche 1 bis 3,
dadurch gekennzeichnet,
daß die den Querträgern (31,34) oder dgl. abgekehrten Seiten der Stege (21) der U-förmigen Halteklammern (20) außerhalb der Lappen (23) verlängert und um 180° auf die Außenseite des Steges (21) umgebogen als Rastfedern (27) ausgebildet sind, die an ihren freien Enden hakenförmig umgebogen sind und mit den umgebogenen Abschnitten die Rastansätze (28) bilden.

5. Vorrichtung nach einem der Ansprüche 1 bis 4,
dadurch gekennzeichnet,
daß die Befestigungsflansche (11,12) der Steckerleiste (10) auf den den Querträgern (31,34) oder dgl. abgekehrten Seiten die Lappen (23) der U-förmigen Halteklammern (20) an mindestens zwei freien Seiten mittels Stegen (14,15) oder Absätzen (16,17) gegen Verdrehen sichern.

6. Vorrichtung nach einem der Ansprüche 1 bis 5,
dadurch gekennzeichnet,
daß die Halteklammern (20) in Bezug auf ihre in Längsrichtung der Steckerleiste (10) verlaufende Mittelebene symmetrisch ausgebildet sind.

7. Vorrichtung nach einem der Ansprüche 1 bis 6,
dadurch gekennzeichnet,
daß die Querträger (31,34) oder dgl. pro Schmalseite der Steckerleiste (10) eine Reihe von Bohrungen (41,42) und eine Reihe von Durchbrüchen (32,33,35) aufweisen, die in Längsrichtung der Querträger (31,34) oder dgl. ausgerichtet und quer dazu aufeinander ausgerichtet sind, und
daß der mittlere Abstand der einander zugeordneten Reihen von Bohrungen (41,42) und Durchbrüchen (32,33,35) dem mittleren Abstand der Befestigungsbohrung (13) im Befestigungsflansch (11,12) der Steckerleiste (10) und der Rastgeber (27) mit dem Rastansatz (28) der auf diesem Befestigungsflansch (11,12) aufgesteckten Halteklammer (20) entspricht.

## Claims

1. A device for mounting pin-carrying connectors (10) to supports (31, 34), plates or the like, the pin-carrying connectors are running into mounting flanges (11, 12) at the narrow sides of the said connectors, onto which flanges are put mounting clips (20) which are provided with engaging springs (27), are capable of being inserted into through-breaks (32, 33, 35) of the said supports or the like and comprise engaging portions (28) grabbing behind the said supports, **characterized in** that the mounting clips (20) are U-shaped in a plane lying along the pin-carrying connectors (10) and transversal to the support (31, 34) or the like, and that the said mounting clips are capable of being put on the mounting flanges (11, 12) in longitudinal direction of the pin-carrying connector (10), from away the end walls of the said connector and in opposite directions.

2. A device according to claim 1 characterized in that the mounting clips (20) and the engaging springs (27) with the engaging portions (28) each are one-piece members stamped and bent out of elastic metal.

3. A device according to claim 1 or 2 characterized in that the U-shaped mounting clips (20) each are formed by an end leg (22) bent at a web (21) and by a lappet (23) stamped and bent out of the web (21), whereat the end legs (22) are on the sides facing the transversal supports (31, 34) or the like and the lappets (23) are on such sides of the mounting flanges (11, 12) of the pin-carrying connector (1) which are turned away from the transversal supports (31, 34).

4. A device according to one of the claims 1 to 3 characterized in that such sides of the webs (21) of the U-shaped mounting clips (20) which are turned away from the transversal supports (31, 34) or the like are extended over the lappets (23), are bent towards the outside of the web (21) at an angle of 180° and are formed as engaging springs (27) which are bent at their free ends like a hook and represent with respect to the bent sections the engaging portions (28).

5. A device according to one of the claims 1 to 4 characterized in that the mounting flanges (11, 12) of the pin-carrying connector (10) secure the lappets (23) of the U-shaped mounting clips (20) at the sides turned away from the transversal supports (31, 34) atleast on two free sides by means of webs (14, 15) or ledges (16, 17) against twisting.

6. A device according to one of the claims 1 to 5 characterized in that the mounting clips (11, 12) are formed symmetrically with respect to their middle plane running in longitudinal direction of the pin-carrying connector (10).

7. A device according to one of the claims 1 to 6 characterized in that the transversal supports (31, 34) or the like comprise per narrow side of the pin-carrying connector (10) a row of bores (41, 42) and a row of through-breaks (32, 33, 35) which run in longitudinal direction of the transversal supports (31, 34) or the like and are matched to each other in a transversal direction and
that the mean distance between the rows of bores (41, 42) and through-breaks (32, 33, 35) respectively assigned to each other corresponds to the mean distance between the drill-holes (13) in the mounting flanges (11, 12) of the pin-carrying connector (10) and the engaging springs (27) respectively with the engaging portions (28), the mounting clips (20) being put on the mounting flanges (11, 12).

## Revendications

1. Dispositif de fixation pour des réglettes à fiches (10) à des supports (31, 34), plaques ou similaires, dans lequel les petits côtés des réglettes à fiches (10) se terminent par des brides de fixation (11, 12) sur lesquelles sont emmanchées les agrafes de fixation (20) avec des ressorts d'encliquetage (27), ressorts d'encliquetage (27) qui peuvent être introduits dans des passages (32, 13, 35) des supports (31, 34) ou similaires, ressorts présentant des épaulements d'encliquetage (28) venant s'engager derrière ces supports,
caractérisé en ce que
les agrafes de fixation (20) sont en forme de U dans un plan le long des réglettes à fiches (10) et transversalement au support (31, 34) ou similaire et peuvent, dans la direction longitudinale de la réglette à fiches (10), depuis les côtés frontaux de cette réglette, être dans des sens orientés l'un vers l'autre emmanchées sur les brides de fixation (11, 12).

2. Dispositif suivant la revendication 1,
caractérisé en ce que
les agrafes de fixation (20) et les ressorts d'encliquetage (27) avec les épaulements d'encliquetage (28) sont chacune fabriquées en une seule pièce sous forme de pièce découpée et cintrée en un métal élastique.

3. Dispositif suivant la revendication 1 ou la revendication 2,
caractérisé en ce que
les agrafes de fixation (20) en forme de U sont chacune constituées par une aile terminale (22) cintrée sur une barrette (21) et par une patte (23) découpée dans cette barrette et cintrée, les ailes terminales (22) s'appliquant sur les côtés des brides de fixation (11, 12) de la réglette à fiches (10) orientés vers les supports (31, 34) ou similaires et les pattes (23) s'appliquant sur les côtés des brides de fixation (11, 12) de la réglette à fiches (10) qui ne sont pas orientés vers les supports (31, 34) ou similaires.

4. Dispositif suivant l'une quelconque des revendications de 1 à 3,
caractérisé en ce que
les côtés des barrettes (21) des agrafes de fixation en forme de U (20) qui ne sont pas orientés vers les supports (31, 34) ou similaires sont, en dehors des pattes (23), prolongés et sont incurvés de 180° sur la face extérieure de la barrette (21) pour constituer des ressorts d'encliquetage (27), qui à leurs extrémités libres sont cintrés en forme de crochet et qui par leurs tronçons cintrés forment les épaulements d'encliquetage (28).

5. Dispositif suivant l'une quelconque des revendications de 1 à 4,
caractérisé en ce que
sur les côtés qui ne sont pas orientés vers les supports (31, 34), les brides de fixation (11, 12) de la réglette à fiches (10) assurent sur au moins deux extrémités libres, au moyen de nervures (14, 15) ou d'épaulements (16, 17), les pattes (23) des agrafes de fixation (20) en forme de U contre la rotation.

6. Dispositif suivant l'une quelconque des revendications de 1 à 5,
caractérisé en ce que
par rapport à plan médian orienté dans la direction longitudinale de la réglette à fiches, les agrafes de fixation (20) sont de forme symétrique.

7. Dispositif suivant l'une quelconque des revendications de 1 à 6,
caractérisé
en ce que les supports (31, 34) ou similaires présentent, pour chaque petit côté de la réglette à fiches (10), une rangée de forures (41, 42) et une rangée de passages (32, 33, 35), rangées qui sont orientées dans la direction longitudinale des supports (31, 34) ou similaires, les forures ou passages étant orientés transversalement aux supports les uns vers les autres, et
en ce que la distance moyenne des rangées de forures (41, 42) et de passages (32, 33, 35) correspond à la distance moyenne entre la forure de fixation (13) dans la bride de fixation (11, 12) de la réglette à fiches (10) et le ressort d'encliquetage (27) avec l'épaulement d'encliquetage (28) de l'agrafe de fixation (20) emmanchée sur cette bride de fixation (11, 12).
